# EUROPEAN PATENT SPECIFICATION

(11) **EP 0 532 314 B1**
(45) Date of publication and mention of the grant of the patent: **02.06.1999**
(21) Application number: 92308227.5
(22) Date of filing: 10.09.1992
(51) Int. Cl.: H01L 21/3205

(54) **A semiconductor device and a process for fabricating same**
Halbleiteranordnung und Verfahren zur Herstellung
Dispositif semi-conducteur et procédé de sa fabrication

(30) Priority: 10.09.1991 JP 230561/91; 26.12.1991 JP 344269/91; 06.04.1992 JP 83688/92
(43) Date of publication of application: 17.03.1993
(73) Proprietor: SHARP KABUSHIKI KAISHA, Osaka 545 (JP)
(72) Inventor: Yoshinouchi, Atsushi, Kashiba-shi, Nara-ken (JP); Tarui, Keiji, Kitakatsuragi-gun, Nara-ken (JP); Yaoi, Yoshihumi, Yamatokoriyama-shi, Nara-ken (JP); Morita, Tatsuo, Soraku-gun, Kyoto (JP); Tsuchimoto, Shuhei, Kitakatsuragi-gun, Nara-ken (JP)
(74) Representative: Brown, Kenneth Richard

(56) References cited:
- PATENT ABSTRACTS OF JAPAN vol. 13, no. 277 (E-778)26 June 1989 & JP-A-1 064 253 ( RICOH CO LTD ) 10 March 1989
- PATENT ABSTRACTS OF JAPAN vol. 12, no. 38 (E-580)4 February 1988 & JP-A-62 193 276 ( CANON INC. ) 25 August 1987
- PATENT ABSTRACTS OF JAPAN vol. 8, no. 213 (E-269)28 September 1984 & JP-A-59 099 713 ( KOGYO GIJUTSUIN ET AL. ) 8 June 1984
- PATENT ABSTRACTS OF JAPAN vol. 9, no. 230 (E-343)17 September 1985 & JP-A-60 086 863 ( FUJITSU KK ) 16 May 1985

## Description

### BACKGROUND OF THE INVENTION

### 1. Field of the Invention:

The present invention relates to a semiconductor device used in display apparatuses and image sensors, and a process for fabricating same.

### 2. Description of the Prior Art:

TFT(Thin Film Transistor)s, known and used for driving liquid crystal display apparatus and image sensors, are usually fabricated by the same process as that used for making integrated circuits (IC). The conventional IC process requires a high temperature such as 1000°C, so as to effect crystallization, form dielectric layers and activate impurities, and when a transparent substrate is required, the substrate is made of quartz. However, a quartz substrate is expensive, and a large substrate increases production costs. On the other hand, there is a trend that the liquid crystal display apparatus and image sensors become larger size and less costly.

In recent years, there has been proposed a low temperature process in which an amorphous layer or polycrystalline layer formed on a glass substrate grows in solid-phase at a low temperature or is subjected to laser annealing, so as to effect crystallization.

In general, the characteristics of field effect transistors such as TFTs greatly depend upon the state of interface of a gate dielectric layer and the polysilicon as a channel. In the conventional high temperature process thermal oxidation forms a gate dielectric layer and channel interface within the channel layer, thereby maintaining a good interfacial condition. In constrast, the conventional low temperature process forms a gate dielectric layer at low temperatures at which no thermal oxidation can occur. So long as no thermal oxidation occurs, after the polysilicon is formed to a desired shape, hydrofluoric acid of the like is used to purify the surface thereof, and then a gate dielectric layer is formed by a sputtering method of by a CVD method. Nevertheless, a sufficiently low interface level density is not achieved. One solution is proposed to this problem. According to the proposal, the formation of the polysilicon layer is followed by the formation of a gate dielectric layer immediately without exposing the polysilicon layer to the atmosphere. However, this process is disadvantageous in that when the gate dielectric layers and the polysilicon layer are formed to a desired shape, a side portion of the polysilicon layer is unavoidably exposed. After the gate electrode is formed, the gate electrode and the exposed side portion of the polysilicon layer are likely to come into contact with each other, thereby causing leakage therebetween.

In forming semiconductor components such as TFTs on a glass substrate, ions of impurities are likely to diffuse into the semiconductor components, and such ion diffusion is likely to unfavorably affect them during cleaning, etching, heat treatment, ion injection, plasma treatment, etc. In the case of TFTs, such impurity ions spread through the channel layer, thereby increasing an off current and worsening the performance of TFTs. There are several proposals for overcoming this difficulty by covering the glass substrate with a silicon nitride (SiN_{Z}), so as to prevent impurity ions from unfavorably affecting the glass substrate. These proposals are disclosed in Japanese Laid-Open Patent Publication Nos. 58-52874, 59-108360, and 59-89436.

The formation of the SiN_{Z} layer on the glass substrate is advantageous in that it prohibits the diffusion of impurity ions into the glass substrate, thereby ensuring that the resulting off current has as good characteristics as those of quartz as shown in following table:

| Substrate | Quartz | Glass | SiO₂ covered Glass | SiN_{z} covered Glass |
|---|---|---|---|---|
| off current (A) | 0 - 10⁻¹¹ | 0 - 10⁻⁷ | 0 - 10⁻⁶ | 0 - 10⁻¹¹ |
| Adherence | - | - | good | poor |

The table shows that full contact of the SiN_{Z} layer with the glass substrate is difficult to achieve, thereby resulting in poor adherence therebetween.

In the case where an amorphous silicon (a-Si) layer is directly formed on the SiN_{Z} layer, and treated by heat to form a polysilicon (p-Si) layer, the silicon core on the SiN_{Z} layer grows so rapidly that good quality of the p-Si layer is difficult to achieve.

When the glass substrate is covered with an SiO₂ layer alone, the layer is kept in tight contact with the substrate, but disadvantageously a large amount of off current is likely to flow. This indicates that irrespective of the presence of the SiO₂ layer, no enhancement of effectiveness results as compared with the glass substrate having no layer formed at all.

### SUMMARY OF THE INVENTION

In one aspect, this invention provides the semiconductor device defined by claim 1, claim 3 or claim 4. The dependent claims 2 and 5 are directed to embodiments of the invention.

In another aspect, this invention provides the process of fabricating the semiconductor device defined by any of claims 6 to 12.

The invention makes possible the advantages of (1) providing a semiconductor device in which impurity ions from a glass substrate are prevented from diffusion into the semiconductor substrate, which is particularly advantageous in restraining an off current when the TFTs of polysilicon are used, (2) providing a semiconductor device in which a covering layer is firmly adhered to the glass substrate against a possible peeling-off during the fabricating process, and/or silicon crystals in the semiconductor layer are enabled to grow into sufficient particle sizes, thereby enhancing the mobility of the crystals, (3) providing a process for fabricating a semiconductor device without the possibility of having particles mixed with the forming dielectric layers, thereby obtaining quality dielectric layers, (4) providing a process for fabricating a semiconductor device which has good adherence owing to SiNₓO_{y} rich in oxygen (nearly y = 2), the content of oxygen diminishing until the SiNₓO_{y} layer becomes an SiNₓ layer (y - 0) which is effective to prohibit the diffusion of impurity ions from the glass substrate, and (5) providing a process for forming a polysilicon layer and a gate dielectric layer successively which enables forming a dielectric layer easily and in sufficient repeatability without affecting a polysilicon layer and a gate dielectric layer after working a polysilicon layer into a predetermined shape.

### BRIEF DESCRIPTION OF THE DRAWINGS

Figure **1** is a schematic cross-section showing a glass substrate covered with a dielectric layer on one side thereof.

Figure **2** is a schematic cross-section showing a glass substrate covered with dielectric layers on both sides thereof.

Figure **3** is a schematic cross-section showing a semiconductor device incorporating the substrate shown in Figure **1**.

Figure **4** is a schematic cross-section showing a second embodiment of the semiconductor device according to the present invention.

Figure **5** is a schematic cross-section showing a third embodiment of the semiconductor device according to the present invention.

Figure **6** is a schematic view showing each of a fourth to a ninth embodiment of the semiconductor device according to the present invention.

Figures **7A-7B** to **13A-13B** are schematic views showing a series of the process of fabricating the semiconductor device shown in Figure **6**, wherein Figures **7A** to **13A** are respectively a cross-section taken along the line A-A' in Figure **6**, and wherein Figures **7B** to **13B** are respectively a cross-section taken along the line B-B' in Figure **6**.

Figure **14** is a graph showing the relationship between time and intensity of illumination with respect to an illumination spectrum of 388 nm of the fourth embodiment shown in Figure **6**.

Figures **15A-15B** to **16A-16B** are schematic views showing a series of the process of fabricating a fifth embodiment according to the present invention, wherein Figures **15A** and **16A** are respectively a cross-section taken along the line A-A' in Figure **6**, and wherein Figures **15B** and **16B** are respectively a cross-section taken along the line B-B' in Figure **6**.

Figure **17** is a graph showing the relationship between time and intensity of illumination with respect to an illumination spectrum of 388 nm of the fifth embodiment shown in Figure **6**.

Figures **18A** and **18B** are schematic views showing a series of the process of fabricating a sixth embodiment according to the present invention, wherein Figure **18A** is a cross-section taken along the line A-A' in Figure **6**, and wherein Figure **18B** is a cross-section taken along the line B-B' in Figure **6**.

Figures **19A** and **19B** are schematic views showing a series of the process of fabricating a seventh embodiment according to the present invention, wherein Figure **19A** is a cross-section taken along the line A-A' in Figure **6**, and wherein Figure **19B** is a cross-section taken along the line B-B' in Figure **6**.

Figures **20A** and **20B** are schematic views showing a series of the process of fabricating an eighth embodiment according to the present invention, wherein Figure **20A** is a cross-section taken along the line A-A' in Figure **6**, and wherein Figure **20B** is a cross-section taken along the line B-B' in Figure **6**.

Figures **21A** and **21B** are schematic views showing a series of the process of fabricating a ninth embodiment according to the present invention, wherein Figure **21A** is a cross-section taken along the line A-A' in Figure **6**, and wherein Figure **21B** is a cross-section taken along the line B-B' in Figure **6**.

Figure **22** is a schematic view showing a thin film transistor for comparison.

Figure **23** is a schematic view showing an active matrix liquid crystal display apparatus incorporating a semiconductor device according to the present invention.

### DESCRIPTION OF THE PREFERRED EMBODIMENTS

### Example 1

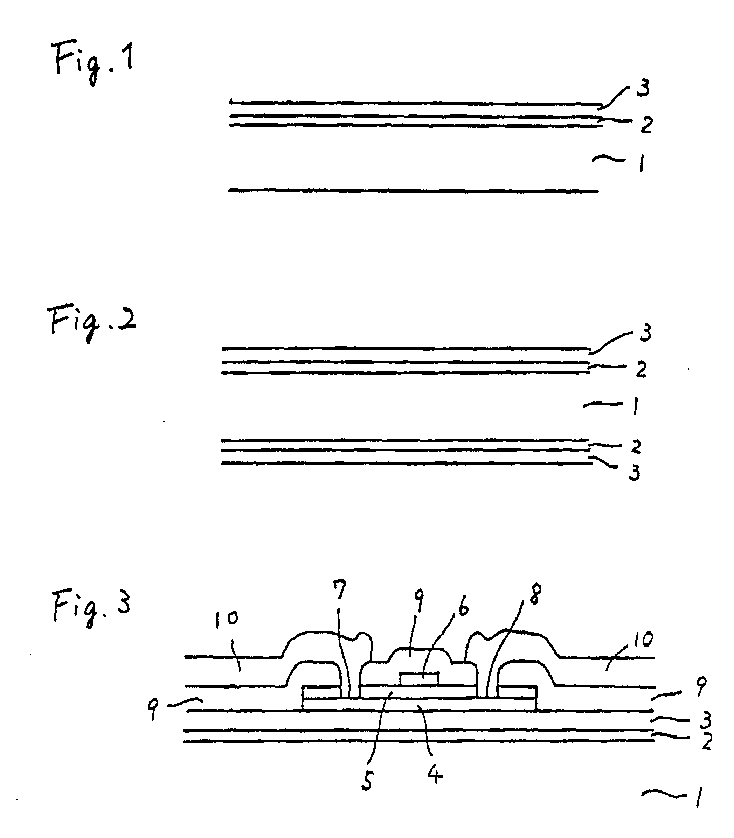

Referring to Figures **1** to **3**, the exemplary embodiment includes a substrate **1** covered with a first layer **2** of SiNₓO_{y} and a second layer **3** of SiN_{z} formed is this order. The examples shown in Figures **1** and **3** have these layers on one side only but the example shown in Figure **2** the substrate **1** is covered with these layers on both sides. In fabricating the examples of Figures **1** and **3**, care must be taken to prevent impurity ions from being lost through the uncovered side of the substrate **1**. In fabricating the example of Figure **2**, it is preferable to form the two layers on both sides of the substrate **1** while the substrate is kept in an erected position. The exemplary embodiment includes the coverage of two layers **2** and **3** but a further set of layers can be formed so as to ensure that impurity ions are prevented from becoming lost.

The layers **2** and **3** are formed in the following manner:

Preferably a reactive sputtering process is used. At first, the first layer **2** of SiNₓO_{y} is formed On the glass substrate **1** by sputtering in a gaseous mixture of nitrogen and oxygen with the use of a silicon target. Under a condition that the flow rate of oxygen was 0.1 to 10%, using a pressure of 0·13 to 2·6 N/m² (1 to 20 mTorr), and the substrate **1** had a temperature of 150 to 300°C, good results were obtained. The thickness of the resulting layer **2** was in the range of 20 to 50 (200 to 500 Å), and the adhesion was found sufficient.

Then, the second layer **3** of SiN_{Z} is formed on the first layer **2**. Sputtering is conducted with the silicon target in a nitrogen atmosphere. Good results were obtained when the gaseous pressure was 0·13 to 2·6 N/m² (1 to 20 mTorr), and the substrate had a temperature of 150 to 300°C. The thickness of the second layer **3** was 50 to 300 (500 to 3000 Å), and this thickness was sufficient to prevent impurity ions from flowing out.

It is possible to add an inert gas such as argon gas to the gaseous atmosphere. It is also possible to form the two layers **2** and **3** in the same apparatus successively. This increases efficiency in production, and the quality of the layers. Instead of the reactive sputtering method, a CVD method can be applied.

After the substrate **1** is covered with the first layer **2** and the second layer 3, a transistor element (semiconductor elements) are formed on the second layer **3** as shown in Figure **3**.

More specifically, after a polysilicon layer **4** is formed on the SiN_{Z} layer **3** as a channel layer for the transistors, and then the layer **4** is patterned to a transistor size which is covered with a gate dielectric layer **5**. The gate dielectric layer **5** is made of SiO₂ but can be made of any other material. The gate layer (unshown) is patterned to form a gate electrode **6**. The gate electrode **6** is made of polysilicon but can be made of any other material if the material is electrically conductive. Subsequently, a contact hole is formed so as to effect an ohmic contact between a source **7** and a drain **8**, and a leader electrode **10**. A dielectric layer **9** and the leader electrode **10** are formed. Finally, hydrogen treatment is conducted so as to remove any dangling bond of the grain boundary in the polysilicon layer **4**.

The characteristics of an off current through the polysilicon transistor formed in this way are the same as the levels (0 to 10⁻¹¹ A) of the off current through a quartz substrate and a glass substrate covered with SiN_{Z}. This indicates that impurities are effectively prohibited from flowing out through the glass substrate. The second SiNₓO_{y} layer ensures a greater adhesion to the glass substrate than the adhesion in the case that a single layer of SiN_{z} is used to the extent so that the bond can withstand a load occurring throughout the whole process of forming the transistors. In addition, the SiN_{z} layer prevents the impurities ion in the glass substrate **1** from diffusing into the transistors.

### Example 2

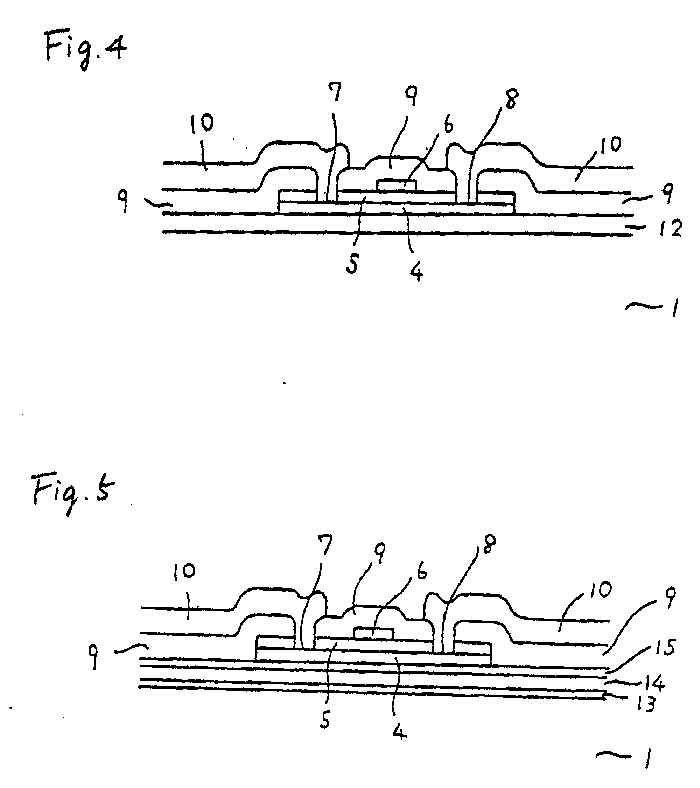

Referring to Figure **4**, the exemplary embodiment has a transistor section having the same structure as that shown in Figure **3**, wherein corresponding components are indicated by same reference numerals.

The glass substrate **1** is covered with a layer **12** of SiNₓO_{y} wherein the values of y vary from **2** to 0 from the boundary between the glass substrate and the layer **12** to the boundary between the layer **12** and the layer **4** in Figure **4**. The layer **12** is formed by a reactive sputtering method.

More specifically, the SiNₓO_{y} layer is formed by a sputtering method with a silicon target in a gaseous mixture of nitrogen and oxygen. Initially, the flow rate of oxygen was in the range of 100 to 10%, and the rate was reduced to 0% as the formation of layer proceeds. After the predetermined period in the rate reaching 0% the formation of the layer ends. As the formation of layer proceeds, the values of **y** vary from 2 to 0 successively to form an SiNₓO_{y}. Good results were obtained when the total pressure was 0·13 to 2·6 N/m² (1 to 20 mTorr), and the substrate **1** had a forming temperature of 150 to 300°C. The thickness of the layer was 50 to 300 (500 to 3000 Å) which was sufficient to secure optimum contact and restraint of impurities. It is possible to add inert gas such as argon to the gaseous mixture. Instead of the reactive sputtering method, a CVD method can be applied. It is possible to form the quality layers efficiently of SiNₓO_{y} successively in the same chamber with the values of **y** being given from 2 to 0 from the substrate.

Since the value of **y** of the SiNₓO_{y} layer **12** near the surface of the glass substrate is in the range of 2, a high adhesion is secured between the substrate and the layer to the extent that the adhesion withstood cleaning, etching, heat treatment, ion implantation, and plasma treatment. The substrate **1** is evenly covred with the SiNₓO_{y} having the value of **y** of 0 so that impurities are prevented from diffusing from the glass substrate 1 into the semiconductor device (transistors). In the illustrated embodiment, the substrate **1** is covered with the SiNₓO_{y} layer on one side but it can be wholly covered including both sides.

### Example 3

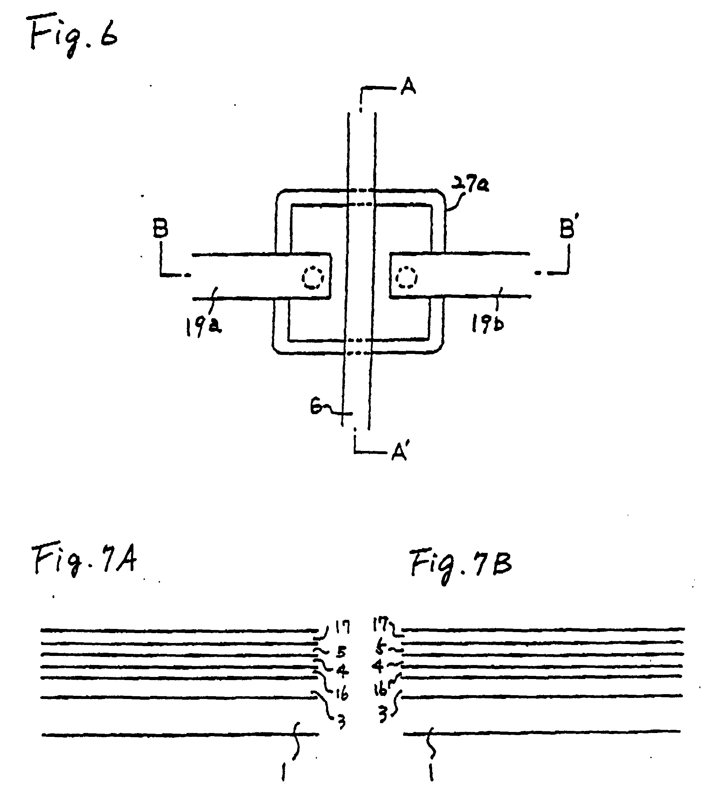

Referring to Figure **5**, a third embodiment will be described:

An SiNₓO_{y} layer **13,** an SiN_{z} layer **14** and an SiO₂ layer **15** are formed on the glass substrate **1**. These three layers are formed by a reactive sputtering method.

More specifically, the SiNₓO_{y} layer **13** is formed on the glass substrate **1** by reactive sputtering method with a silicon target. The layer **13** was formed under the conditions in which the substrate **1** had a temperature of 200°C, the RF power was 750 W, the gaseous pressure was 1·60 N/m² (12 mTorr), the flow rate of N₂ gas was 50 sccm (standard cubic centimeter per minute), and the flow rate of O₂ was 5 sccm or less. Then, in the same chamber, the SiN_{z} layer **14** is formed to 240nm (2400 Å) under the same conditions except for the supply of oxygen. Then, in the same chamber the target was replaced with an SiO₂ target, and the SiO₂ layer **15** was formed to about 50 nm (500 Å) under the conditions in which the substrate had a temperature of 200°C, the power RF was 750 W, the gaseous pressure was 0·65 N/m² (5 mTorr), the flow rate of argon gas was 70 sccm, and the flow rate of oxygen was 30 sccm.

Subsequently, an amorphous Si layer was formed to about 100 nm (1000 Å) by means of a plasma CVD apparatus, and this layer was subjected to furnace annealing to form a polysilicon layer which was patterned to form a resist pattern to a desired shape and subjected to etching. Then, the gate dielectric layer **5** was formed to about 100 nm (1000 Å) by means of a sputtering apparatus. Then, a polysilicon layer, which becomes a gate electrode **6**, was formed to about 200 nm (2000 Å) by a vacuum CVD apparatus, and this polysilicon layer was patterned to form a resist pattern to a desired shape and was subjected to etching by use of a reactive ion etcher. Then P⁺ ion was implanted into the entire surface of the layer, and subjected to activating annealing so as to reduce the resistance of the gate electrode **6**, and to reduce the resistance of the source area **7** and the drain area **8** and activate them. Then an SiO₂ layer was formed to about 500 nm (5000 Å) by a normal pressure CVD apparatus in which a contact hole was formed to form a dielectric interlayer **9**. The gate dielectric layer **5** is provided with a hole so as to connect the source area **7** and drain area **8** to an aluminum electrode **10** which is formed later. Finally, aluminum was formed into an aluminum layer having a thickness of about 1 µm so as to form the aluminum electrode **10**.

**Table 1**

| Flow Rate of O₂ (sccm) | Peeling-Off |
|---|---|
| 0 | occurred |
| 1 | nil |
| 3 | nil |
| 5 | nil |
| 10 | occurred |
| 20 | occurred |

Table 1 shows the relationship between the flow rate of oxygen gas as one condition of forming conditions of SiNₓO_{y} layer **13** and the peeling of SiNₓO_{y} layer **13**. It will be understood from Table 1 that when the flow rate of O₂ exceeds 10 sccm, the resulting layer is more easily peeled because the content of SiO₂ increases. When the flow rate of O₂ is too low, separation from the substrate is likely to occur.

**Table 2**

| SiNₓO_{y} (Å) | Peeling-Off |
|---|---|
| 100 | occurred |
| 300 | occurred |
| 600 | nil |
| 1000 | nil |
| 2000 | nil |

Table 2 shows the relationship between the thicknesses of the SiNₓO_{y} layers **13** and the separation thereof. It will be understood from Table 2 that when the thickness of the layer **13** remains below 300 Å, separation is likely to occur.

In the exemplary embodiment the three layers between the glass substrate and the active layer are formed by a sputtering method with the use of the Si target for the SiNₓO_{y} layer **13** and SiN_{z} layer **14** and the SiO₂ target for the SiO₂ layer **15**. Instead of the sputtering method, a CVD method can be used. Under certain conditions, however, the SiNₓO_{y} layer **13** is not necessarily required.

According to the present invention, impurities are prevented from diffusion into the semiconductor elements which would otherwise be likely to occur in fabricating TFTs on the glass substrate. In addition, a quality polysilicon layer is formed by the method of heat treating an amorphous silicon layer to a polysilicon layer. The interposition of an SiNₓO_{y} between the substrate and the SiN_{z} solves the problem of detrimental separation of the SiN_{z}. Furthermore, the formation of a succession of layers in the same chamber advantageously prevents impurities such as particles from being mixed with these layers.

### Example 4

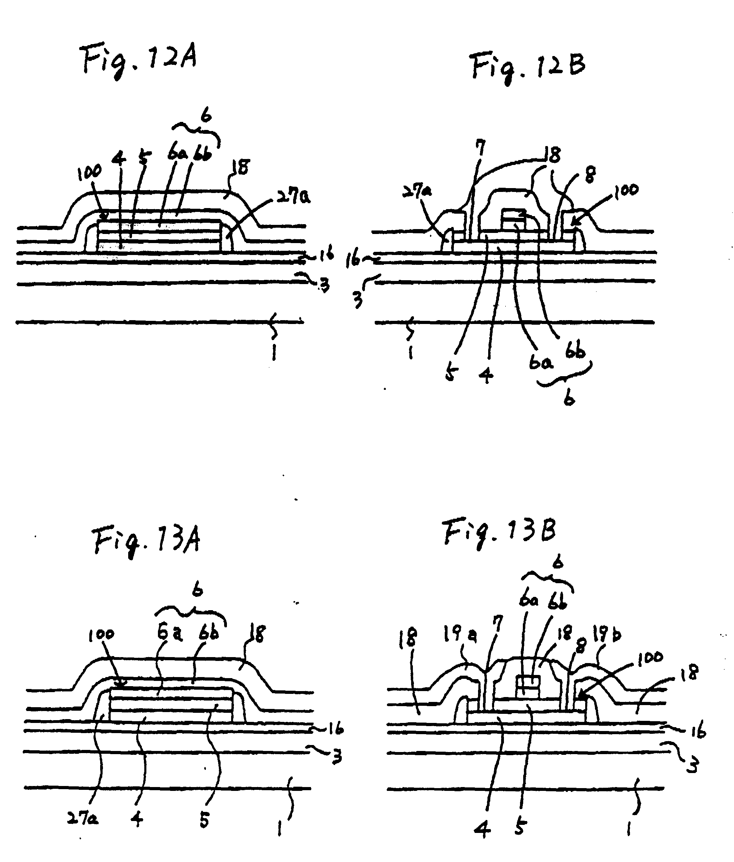

Referring to Figures **6** to **13A, 13B,** first, an SiN layer **3** was formed to about 3000 Å on a cleaned glass substrate **1** by a sputtering method or a CVD method. Then, an SiO₂ layer **16** was formed to about 500 Å by a sputtering method or a CVD method. Then, an amorphous silicon layer was formed to about 1000 Å on the SiO₂ layer **16** by a plasma CVD method, wherein the substrate had a temperature of 400 to 600°C, SiH₄ gas was diluted with hydrogen gas, subjected to decomposition by heat and plasma.

In order to obtain a polysilicon layer **4** from the amorphous silicon layer, the amorphous layer was annealed at 600°C at vacuum or in an inert gas atmosphere for about 50 hours. An SiO₂ layer **5**, which becomes a gate dielectric layer later, was formed to about 1000 Å by a vacuum CVD apparatus. In the process of fabricating the gate dielectric layer from fabricating the amorphous silicon, the glass substrate was moved from the plasma CVD apparatus to the annealing furnace, and from the annealing furnace to the vacuum CVD apparatus. This movement of the glass substrate takes place in a load lock chamber at vacuum or filled with an inert gas atmosphere.

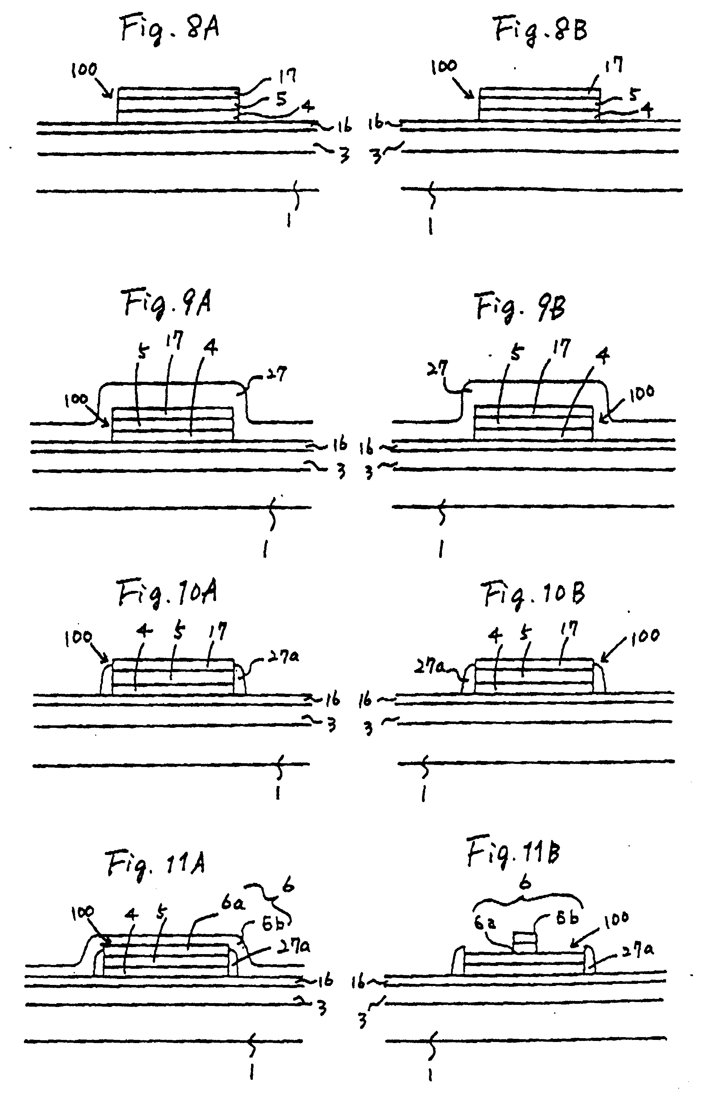

Figures **7A** and **7B** show multilayers in which a polysilicon layer **17**, which becomes a lower gate electrode **6a**, was formed to about 1000 Å by a vacuum CVD apparatus. Each of the three layers **4, 5** and **17** on the SiO₂ layer **16** was etched by the same resist pattern to form an island-shaped pattern **100** as shown in Figure **8A**. The etching of each of layers **4, 5** and **17** was carried out with the use of a reactive ion etcher, and it was an anisotropic etching so as to ensure that the vertical cross-sectional surface of the etched layer **4**, **5**, and **17** remained perpendicular to the substrate **1**. The etching of the polysilicon layer **17** used a gaseous mixture of SF₆ and CCl₄ as etching gas and that for the SiO₂ used CHF₃.

Then, as shown in Figures **9A** and **9B** the entire surface of the glass substrate 1 was covered with an SiN layer **27** formed to about 5000 Å by a sputtering method or a CVD method. Then, an anisotropic etching was carried out on the SiN layer **27** with CHF₃ as a reactive gas by use of a reactive ion etcher so as to erode the SiN layer **27**. In this way the SiN layer **27** diminishes until portions **27a** thereof remain on each side surface of the island-shaped pattern **100** as shown in Figures **10A** and **10B**.

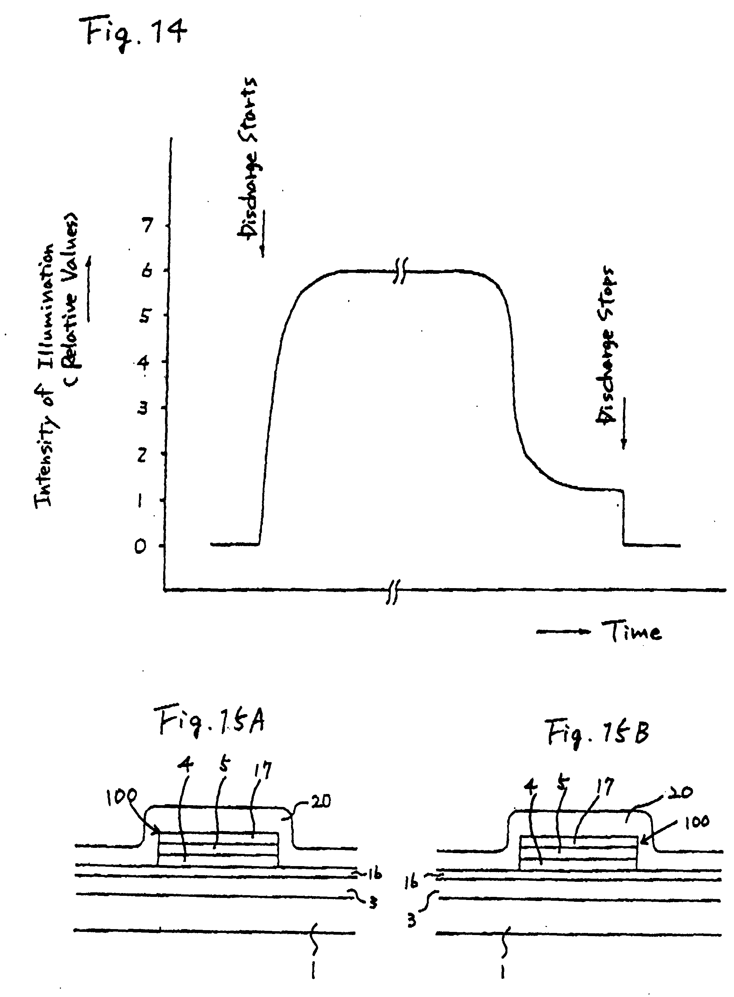

Figure **14** shows the relationship between time and intensity of emission with respect to a CN spectrum of 388 nm in a plasma emission spectrum at reactive ion etching arising from the etching gas CHF₃ and SiN layer **3**, wherein the time starts immediately after the etching was started. It will be understood from the graph that the intensity of emission becomes suddenly low at a certain point of time, from which it will be understood that the SiO₂ layer **16** was exposed at this point of time. It was preferred that the etching operation should be stopped after it was confirmed that the intensity of emission becomes lowest, the etching was finished, and this ensures that the size of the remaining portions **27a** of the SiN layer **27** on the side surface of the island shaped pattern **100** can be constant. In this case, a possible reduction in thickness of the lower gate electrode **6a** which forms a top surface of the island-shaped pattern **100** was as negligible as about 50 Å.

In order to secure constantly the SiN layer portions **27a** to the side surface of the island-shaped pattern **100**, it was possible to select the etching ratio of the lower gate electrode **6a** and the SiN layer **27** covered thereon to etch the SiN layer **27**.

Then, a polysilicon layer, which becomes the upper gate electrode **6b,** was formed to about 2000 Å by a vacuum CVD apparatus, and as shown in Figures **11A** and **11B**, after a resist pattern was prepared in a desired shape, the lower gate electrode **6a** and the upper gate electrode **6b** are etched together with the use of a reactive ion etcher so as to form a gate electrode **6**.

Then, the entire surface of the polysilicon layer was subjected to ion implanting to activating anneal, so as to reduce the resistance thereof, wherein the treating polysilicon layers include the lower gate electrode **6a**, the upper gate electrode **6b**, and a source/drain region **7/8.**

Then, as shown in Figure **12A**, the whole substrate **1** was covered with an SiO₂ layer or a PSG layer doped P (phosphor), and a contact hole was made to form a dielectric interlayer **18**. Another hole was made in the gate dielectric layer **5** so as to connect the source/drain region **7/8** to an aluminum electrode which was later formed. Although it is not shown in the drawings, another contact hole was also made in the layer on the gate electrode **6** to be connected to the aluminum wiring which is later formed.

Subsequently, an aluminum layer was formed to about 5000 Å by a sputtering apparatus, and was formed to a desired shape so as to form a source electrode **19a** and a drain electrode **19b**. Figure **13B** shows an entity having the source electrode **19a**, the drain electrode **19b**, TFTs, and peripheral wiring.

### Example 5

Referring to Figures **6** and **15A-15B** to **16A-16B**, a fifth embodiment will be described:

In this embodiment, an SiO₂ layer was used instead of the SiN layer **27** in Example 4. The process up to Figures **8A** and **8B** was also carried out, and a description is omitted.

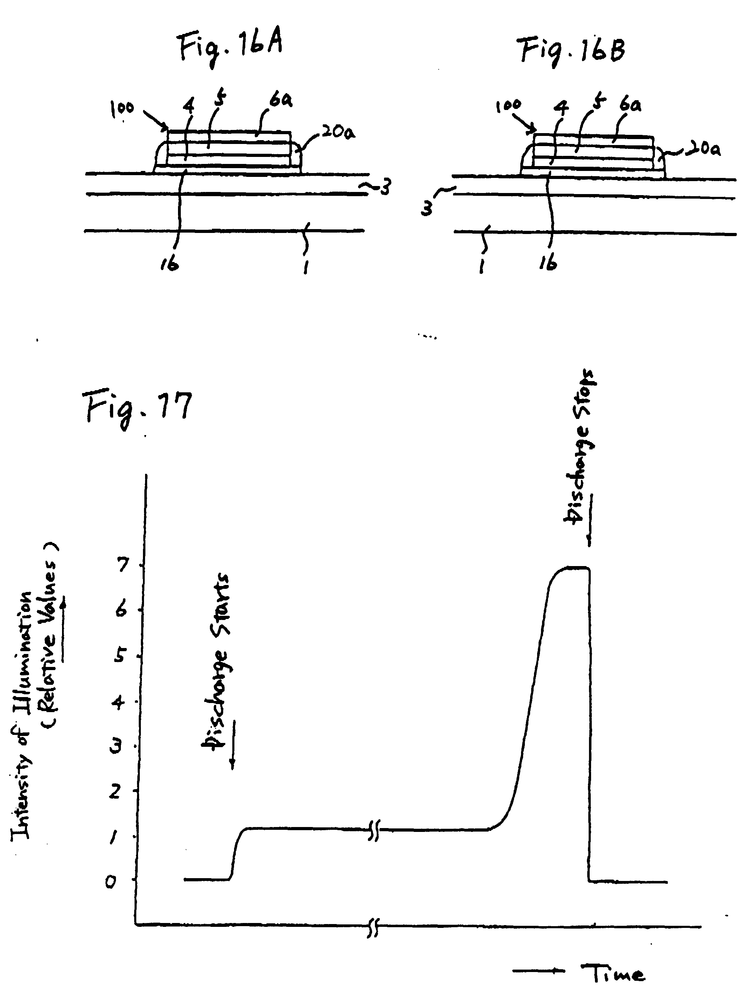

After the island-shaped pattern **100** was patterned as shown in Figure **15A,** the whole surface of the substrate **1** was covered with an SiO₂ layer **20** formed to about 5000 Å by a normal pressure CVD apparatus. Then, as shown in Figure **16A,** the SiO₂ layer **20** was subjected to an anisotropic etching with the use of a reactive CHF₃ gas by the reactive ion etcher so as to reduce the SiO₂ layer **20** until it remained as a portion **20a** on the side surface of the island-shaped pattern **100.**

Likewise, the etching period of time was controlled through variations in the intensity of emission of the plasma emission spectrum. After the SiO₂ layers **20** and **16** were etched, the lower gate electrode **6a** and the SiO₂ layer **16** on the substrate **1** are exposed. Since the lower gate electrode **6a** occupies only a small area to a whole area of the glass substrate **1**, the influence upon the spectrum is negligible.

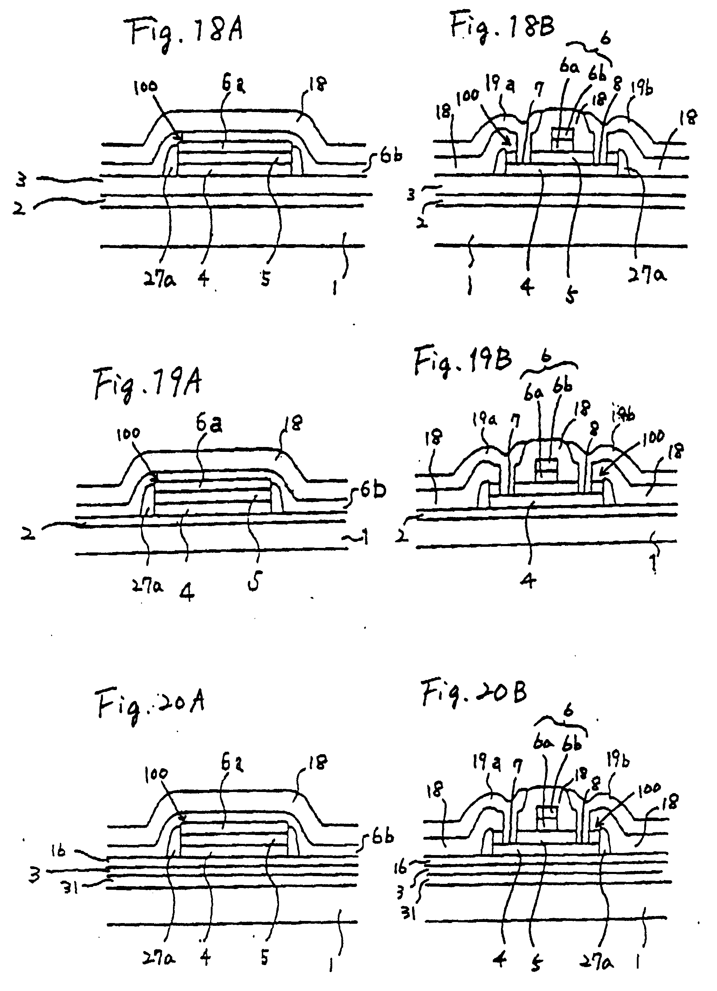

Since the surface of the substrate **1** was also made of SiO₂ layer **16**, no change occurred in the emission spectrum. Accordingly, the SiO₂ layer **16** was concontinuously etched until the top surface of the SiN layer **3** as a layer preventing impurities from diffusing was exposed. Figure **17** shows the relationship between time and intensity of emission with respect to a CN spectrum of 388 nm arising from the etching gas CHF₃ and SiN layer **3**, wherein the time starts immediately from the start of the etching. It will be understood from the graph that the intensity of emission becomes suddenly high at a certain point of time, from which it will be understood that the SiN layer 3 was exposed at this point of time. It was preferred that the etching operation should be stopped after it was confirmed that the intensity of emission became high, the etching was finished, and this ensures that the size of the remaining portions **20a** of the SiO₂ layer **20** on the side surface of the island-shaped pattern **100** can be constant. As compared with Example **4**, the SiO₂ layer **16** on the substrate 1 was slightly excessively etched. Thus, the size of the remaining portion **20a** was slightly diminished but its dielectric strength was not spoiled but remains sufficiently effective.

In this embodiment, the SiO₂ layer **16** is formed to 500 Å in thickness. As the SiO₂ layer 16 becomes thicker, the remaining portion **20a** of the SiO₂ becomes smaller. An optimum thickness is 1000 Å or less. In this case, the reduction of the thickness of the lower gate electrode **6a** was only 100 Å.

The process subsequent to the formation of the upper gate electrode **6b** is the same as that taken in Example 4. It is possible to etch the SiO₂ layer **20** alone because the upper surface of the island-shaped pattern **100** is made of polysilicon layer which is the lower gate electrode **6a.**

### Example 6

Referring to Figures **6**, **18A** and **18B**, a sixth embodiment will be described:

In this embodiment, an SiNₓO_{y} layer and an SiN_{z} layer are formed one above another as a first set of dielectric layers instead of the SiN layer **3** and SiO₂ layer **16** in Example 4.

Referring to Figures **18A** and **18B**, a cleaned glass substrate **1** was prepared, and an SiNₓO_{y} layer **2** was formed on the substrate **1** by a reactive sputtering apparatus, with the silicon target in a gaseous mixture of nitrogen and oxygen. A good result was obtained when the flow rate of oxygen was 0.1 to 10%, having a total pressure of 0·13 to 2·6 N/m² (1 to 20 mTorr), and the substrate had a temperature of 150 to 300°C. The resulting SiN_{X}O_{y} layer **2** had a thickness of 20 to 50 nm (200 to 500 Å), and the adherence was sufficient.

Then, an SiN_{z} layer **3** was formed on the SiNₓO_{y} layer **2** in the following manner:

An SiN_{z} layer 3 was formed on an SiNₓO_{y} layer **2** by a sputtering method with a silicon target in a nitrogen gaseous atmosphere. A good result was obtained when the gas pressure was 1 to 20 mTorr, the substrate **1** had a temperature of 150 to 300°C. The resulting layer **3** had a thickness of 500 to 3000 Å, and it was found that the SiN_{z} layer **3** was effective to confine impurities in the substrate **1**.

It is possible to add an inert gas such as argon to the gaseous atmosphere. Preferably, the SiNₓO_{y} layer **2** and the SiN_{z} layer **3** are successively formed in the same chamber, which increases the production efficiency and quality of the layers **2** and **3**. Instead of the reactive sputtering method, a CVD method can be used.

TFTs were formed on the SiN_{z} layer **3**, and etching was conducted until the top surface of the SiN_{z} layer **3** was exposed, SiN_{z} layer **3** is a layer preventing impurities from diffusing. The etching was finished when it was detected that the CN spectrum of 388 nm reaches the maximum intensity of emission, thereby ensuring that the size of the remaining portion **27a** of the SiO₂ layer on the side surface of a island shaped pattern can be constant. In this embodiment, because the SiNₓO_{y} layer firmly adhered to the glass substrate **1** is formed on the glass substrate **1** the SiNₓO_{y} layer is prevented from peeling off.

### Example 7

Referring to Figures **6**, **19A** and **19B**, a seventh embodiment will be described:

An SiNₓO_{y} layer **2** was formed on a glass substrate 1 as a first dielectric layer, wherein the value of **y** varies from 2 to 0 above the boundary between the substrate and the SiNₓO_{y} layer **2**. The formation of the SiNₓO_{y} layer **2** was effected by a reactive sputtering apparatus as follows:

Reactive sputtering was conducted in a gaseous mixture of nitrogen and oxygen with a silicon target. In the initial period of time the flow rate of oxygen was in the range of 100 to 10%, and as the process proceeds, the flow rate of oxygen drops to 0% under which the layer was formed for a given period of time, and then the value of y of the SiNₓO_{y} layer **2** varies from 2 to 0. In this way the SiNₓO_{y} layer **2** was formed. A good result was obtained when the total pressure was in the range of 0·13 to 2·6 N/m² (1 to 20 mTorr), and the substrate **1** had a temperature of 150 to 300°C. The thickness of the resulting layer **2** was in the range of 50 to 300 nm (500 to 3000Å).

TFTs are formed on the SiNₓO_{y} layer **2**. Good adherence between the substrate **1** and the SiNₓO_{y} layer **2** was achieved.

### Example 8

Referring to Figures **6**, **20A** and **20B**, first, as a set of first dielectric layers, an SiO:N layer **31,** an SiN layer **3** and an SiO₂ layer **16** are successively formed on a glass substrate **1** and as a second dielectric layer an SiN layer was formed as a remainder **27a** around the island-shaped pattern **100** as Example 4.

A cleaned glass substrate **1** was prepared, and the SiO:N layer **31** and the SiN layer **3** are formed to about 600 Å on the glass substrate **1** in the same manner as Example **3**. And the SiO₂ layer **16** is formed to 500 Å in the same chamber with an SiO₂ target under the condition in which the substrate had a temperature of 200°C, RF power was 750 W, the gaseous pressure was 5 mTorr, the flow rate of Ar was 70 sccm, and the flow rate of O₂ was 30 sccm. TFTs are formed on the SiO₂ **16** are formed in the same manner as Example 4. A good adherence between the substrate **1** and the dielectric layers **31, 3, 16,** and the semiconductor layer **4** had large crystalline particles of silicon, and high mobility was achieved.

### Example 9

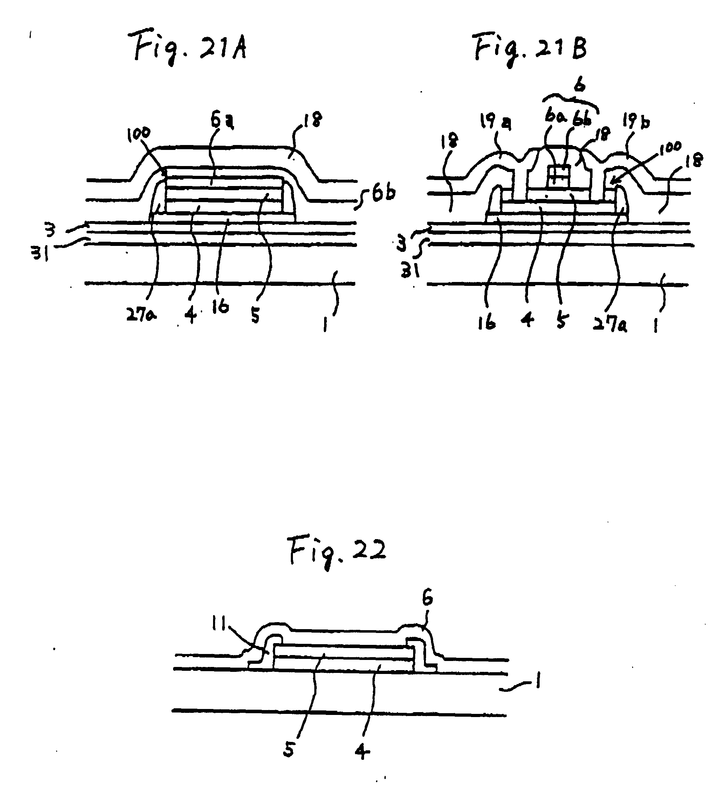

Referring to Figures **6**, **21A** and **21B,** a ninth embodiment will be described:

Similarly with Example 8, as a set of first dielectric layers, that is, an SiO:N layer **31,** an SiN layer **3** and an SiO₂ layer **16** are successively formed on a glass substrate **1**, and as a second dielectric layer an SiO₂ layer remained as a remaining portion **27a** around the island-shaped multilayer pattern **100**. TFTs were formed on the SiO₂ layer **16** in the same manner as Example **8**. Adherence between the glass substrate **1** and the first dielectric layers was satisfactory, and the crystalline particles were large in size so as to secure high mobility.

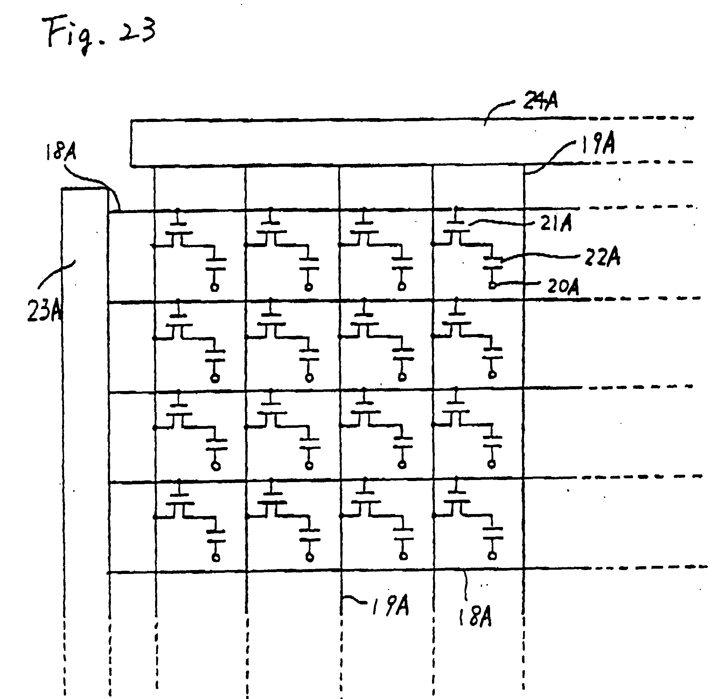

Figure **23** shows an example of an active matrix type liquid crystal display apparatus to which the TFTs obtained by any of Examples 4 to 9 are applied. In Figure **23,** the display apparatus includes a gate bus **18A,** a source bus **19A,** a common line **20A**, TFTs **21A,** and a liquid crystal **22A.** The TFTs **21A** of the present invention can be used not only in the gate scanning circuit **23A** and the data driver circuit **24A** but also in each pixel because of their high mobility.

It will be appreciated from Examples 4 to 9 that the set of first dielectric layers prevent impurities from diffusing from the substrate because of the SiN_{z} layer contained therein, good adherence of the first dielectric layers to the glass substrate was maintained because of an oxygen-content silicon compound layer present therebetween, thereby preventing the dielectric layers from peeling off during the production process. In addition, large crystalline particles grow because of oxygen-content silicon compound layers present between the layers and the substrate.

A portion of the dielectric layer which was first overlaid on the substrate remains on the side of the island-patterned layer simply by an anisotropic etching. The etching period of time can be precisely controlled through a spectroscopic analysis of plasma. The size of the remaining portion **27a** can be made constant.

The content of oxygen in the SiNₓO_{y} layer is successively varied from 2 (y = 2) to 0 (y = 0). When the SiNₓO_{y} layer is rich in oxygen as y = 2, the semiconductor device has good adherence between the substrate and the SiNₓO_{y} layer owing to the oxygen content. When the content of oxygen diminishes and the SiN_{X}O_{y} layer becomes an SiNₓ layer (y = 0), the SiNₓ layer is effective to prohibit the diffusion of impurity ions from the glass substrate during cleaning, etching, heat treatment, ion injection, and plasma treatment; for example, in the case of polysilicon TFTs an off current is prevented from increasing, thereby maintaining good characteristics of transistor.

## Claims

1. A semiconductor device comprising a dielectric substrate (1) made of glass including impurity ions, a covering layer formed on the glass substrate, a semiconductor layer (4), a gate dielectric layer (5) and a gate electrode (6;6a), the covering layer comprising a first layer (2;13;31) formed toward the glass substrate (1) and a second layer (3;14) formed toward the semiconductor layer (4), the first layer being a SiNₓO_{y} (x≠0,y≠0) layer and the second layer being a SiN_{z} (z≠0) layer.

2. A semiconductor device according to claim 1, wherein said covering layer further comprises a third layer (15;16) formed on the second layer (14;3) toward the semiconductor layer, said third layer being a SiO₂ layer.

3. A semiconductor device comprising a dielectric substrate (1) made of glass including impurity ions, a covering layer formed on the glass substrate, a semiconductor layer (4), a gate dielectric layer (5) and a gate electrode (6a), the covering layer comprising a first layer (3) formed toward the glass substrate (1) and a second layer (16) formed toward the semiconductor layer (4), the first layer (3) being a SiN_{z} (z≠0) layer and the second layer (16) being a SiO₂ layer.

4. A semiconductor device comprising a dielectric substrate (1) made of glass including impurity ions, a covering layer (12;2) formed on the glass substrate, a semiconductor layer (4), a gate dielectric layer (5) and a gate electrode (6;6a), the covering layer being an SiNₓO_{y} layer with the value of y continuously varying from 2 to 0 away from the glass substrate (1).

5. A semiconductor device according to any of claims 1 to 5, said covering layer constituting a first dielectric entity, and said semiconductor layer (4), said gate dielectric layer (5) and said gate electrode (6a) together constituting a multilayer island (100) formed on said first dielectric entity; the device further comprising a second dielectric entity (27a;20a) formed around the side of the multilayer island (100), and an upper gate electrode (6b) formed on the first-mentioned gate electrode (6a).

6. A process of fabricating a semiconductor device, the process comprising the steps of preparing a dielectric substrate (1) made of glass including impurity ions, forming a first SiN_{z} (z≠0) layer (3) followed by a second SiO₂ layer (16) above the SiN_{z} layer on at least one side of the glass substrate successively within the same chamber, and forming TFTs on the second layer (16).

7. A process of fabricating a semiconductor device according to claim 6, the process comprising the steps of forming a multilayer including a semiconductor layer (4) on the dielectric entity of the SiN_{z} and SiO₂ layer, forming a gate dielectric layer (5) on the semiconductor layer, and forming a lower gate electrode layer (6a) on the gate dielectric layer, selectively removing the multilayer so that the remaining portion has the form of an island (100), forming a second dielectric entity (27a;20a) around the side of the island, forming an upper gate electrode layer (6b) on the lower gate electrode layer, and etching the upper gate electrode layer and the lower gate electrode layer using the same resist pattern.

8. A process of fabricating a semiconductor device, the process comprising the steps of preparing a dielectric substrate (1) made of glass including impurity ions, forming a dielectric entity comprising at least an SiNₓO_{y} (x≠0,y≠0) layer (2;13;31) followed by an SiN_{z} (z≠0) layer (3;14;3) above the SiN_{z}O_{y} layer on at least one side of the glass substrate, and forming a TFT on the dielectric entity.

9. A process according to claim 8, wherein the formation of said TFT comprises the steps of: forming a multilayer which includes a semiconductor layer (4) formed on the dielectric entity, a gate dielectric layer (5) on the semiconductor layer, and a lower gate electrode layer (6a) on the gate dielectric layer, selectively removing the multilayer so that the remaining portion has the form of an island (100), forming a further dielectric entity (27a) around the side of the island, forming an upper gate electrode layer (6b) on the lower gate electrode layer, and etching the upper gate electrode layer and the lower gate electrode layer using the same resist pattern.

10. A process according to claim 8, wherein the layers of the dielectric entity are formed within the same chamber.

11. A process of fabricating a semiconductor device, the process comprising the steps of preparing a dielectric substrate (1) made of glass including impurity ions, forming a dielectric entity comprising an SiNₓO_{y} layer (12;2) on at least one side of the glass substrate, and forming TFTs on the dielectric entity, wherein the SiNₓO_{y} layer has a value of y varying continuously from 2 to 0 away from the glass substrate.

12. A process according to any of claims 9 to 11, wherein the or each layer of the dielectric entity is formed by a reactive sputtering method.

## Patentansprüche

1. Halbleiterbauteil mit einem dielektrischen Substrat (1) aus Glas, das Fremdstoffionen enthält, einer auf dem Glassubstrat hergestellten Deckschicht, einer Halbleiterschicht (4), einer dielektrischen Gateschicht (5) und einer Gateelektrode (6; 6a), wobei die Deckschicht eine erste, zum Glassubstrat (1) hin ausgebildete Schicht (2; 13; 31) und eine zweite, zur Halbleiterschicht (4) hin ausgebildete Schicht (3; 14) aufweist, wobei die erste Schicht eine SiNₓOy(x≠0, y≠0)-Schicht und die zweite Schicht eine SiN_{z}-(z≠0)-Schicht ist.

2. Halbleiterbauteil nach Anspruch 1, bei dem die Deckschicht ferner eine dritte Schicht (15; 16) aufweist, die auf der zweiten Schicht (14; 3) zur Halbleiterschicht hin ausgebildet ist und eine SiO₂-Schicht ist.

3. Halbleiterbauteil mit einem dielektrischen Substrat (1) aus Glas, das Fremdstoffionen enthält, einer auf dem Glassubstrat hergestellten Deckschicht, einer Halbleiterschicht (4), einer dielektrischen Gateschicht (5) und einer Gateelektrode (6; 6a), wobei die Deckschicht eine erste, zum Glassubstrat (1) hin ausgebildete Schicht (3) und eine zweite, zur Halbleiterschicht (4) hin ausgebildete Schicht (16) aufweist, wobei die erste Schicht eine SiN_{z}(z≠0)-Schicht und die zweite Schicht eine SiO₂-Schicht ist.

4. Halbleiterbauteil mit einem dielektrischen Substrat (1) aus Glas, das Fremdstoffionen enthält, einer auf dem Glassubstrat hergestellten Deckschicht (12;2), einer Halbleiterschicht (4), einer dielektrischen Schicht (5) und einer Gateelektrode (6; 6a), wobei die Deckschicht eine SiNₓO_{y}-Schicht ist, wobei der Wert y vom Glassubstrat (1) weg kontinuierlich von 2 bis 0 variiert.

5. Halbleiterbauteil nach einem der Ansprüche 1 bis 5, bei dem die Deckschicht eine erste dielektrische Einheit bildet und die Halbleiterschicht (4) die elektrische Gateschicht (5) und die Gateelektrode (6a) gemeinsam eine auf der ersten dielektrischen Einheit hergestellte mehrschichtige Insel (100) bilden, wobei das Bauteil ferner eine zweite, um die Seite der mehrschichtigen Insel (100) herum hergestellte dielektrische Einheit (27a; 20a) und eine auf der erstgenannten Gateelektrode (6a) hergestellte obere Gateelektrode (6b) aufweist.

6. Verfahren zum Herstellen eines Halbleiterbauteils mit den Schritten des Bereitstellens eines dielektrischen Substrats (1) aus Glas, das Fremdstoffionen enthält, des Herstellens einer ersten SiN_{z}(z≠0)-Schicht (3) gefolgt von einer zweiten SiO₂-Schicht (16) auf der SiN_{z}-Schicht auf mindestens einer Seite des Glassubstrats in aufeinanderfolgender Weise innerhalb derselben Kammer, und des Herstellens von TFTs auf der zweiten Schicht (16).

7. Verfahren zum Herstellen eines Halbleiterbauteils nach Anspruch 6 mit den Schritten des Herstellens einer Mehrfachschicht einschließlich einer Halbleiterschicht (4) auf der dielektrischen Einheit aus der SiN_{z}- und der SiO₂-Schicht, des Herstellens einer dielektrischen Gateschicht (5) auf der Halbleiterschicht und des Herstellens einer unteren Gateelektrodenschicht (6a) auf der dielektrischen Gateschicht, des selektiven Entfernens der Mehrfachschicht in solcher Weise, dass der verbliebene Teil die Form einer Insel (100) aufweist, des Herstellens einer zweiten dielektrischen Einheit (27a; 20a) um die Seite der Insel herum, des Herstellens einer oberen Gateelektrodenschicht (6b) auf der unteren Gateelektrodenschicht sowie des Ätzens der oberen Gateelektrodenschicht und der unteren Gateelektrodenschicht unter Verwendung desselben Resistmusters.

8. Verfahren zum Herstellen eines Halbleiterbauteils mit den Schritten des Bereitstellens eines dielektrischen Substrats (1) aus Glas, das Fremdstoffionen enthält, des Herstellens einer dielektrischen Einheit mit mindestens einer SiNₓO_{y} (x≠0, y≠0)-Schicht (2; 13; 31), gefolgt von einer SiN_{z}(z≠0)-Schicht (3; 14; 3) auf der SiNₓO_{y}-Schicht auf mindestens einer Seite des Glassubstrats, und des Herstellens eines TFT auf der dielektrischen Einheit.

9. Verfahren nach Anspruch 8, bei dem die Herstellung des TFT die folgenden Schritte umfasst: Herstellen einer Mehrfachschicht mit einer Halbleiterschicht (4) auf der dielektrischen Einheit, einer dielektrischen Gateschicht (5) auf der Halbleiterschicht und einer unteren Gateelektrodenschicht (6a) auf der dielektrischen Gateschicht, selektives Entfernen der Mehrfachschicht in solcher Weise, dass der verbliebene Teil die Form einer Insel (100) aufweist, Herstellen einer weiteren dielektrischen Einheit (27a) um die Seite der Insel herum, Herstellen einer oberen Gateelektrodenschicht (6b) auf der unteren Gateelektrodenschicht sowie Ätzen der oberen Gateelektrodenschicht und der unteren Gateelektrodenschicht unter Verwendung desselben Resistmusters.

10. Verfahren nach Anspruch 8, bei dem die Schichten der dielektrischen Einheit innerhalb derselben Kammer hergestellt werden.

11. Verfahren zum Herstellen eines Halbleiterbauteils mit den Schritten des Bereitstellens eines dielektrischen Substrats (1) aus Glas, das Fremdstoffionen enthält, des Herstellens einer dielektrischen Einheit mit einer SiNₓO_{y}-Schicht (12; 2) auf mindestens einer Seite des Glassubstrats sowie des Herstellens von TFTs auf der dielektrischen Einheit, wobei die SiNₓO_{y}-Schicht hinsichtlich y einen Wert aufweist, der vom Glassubstrat weg kontinuierlich von 2 bis 0 variiert.

12. Verfahren nach einem der Ansprüche 9 bis 11, bei dem die oder jede Schicht der dielektrischen Einheit durch ein reaktives Sputterverfahren hergestellt wird.

## Revendications

1. Dispositif à semi-conducteur comprenant un substrat diélectrique (1) constitué d'un verre comprenant des ions d'impureté, une couche de couverture formée sur le substrat de verre, une couche semi-conductrice (4), une couche diélectrique de grille (5) et une électrode de grille (6 ; 6a), la couche de couverture comprenant une première couche (2 ; 13 ; 31) formée en regard du substrat de verre (1), et une deuxième couche (3 ; 14) formée en regard de la couche semi-conductrice (4), la première couche étant une couche de SiNₓO_{y} (x ≠ 0, y ≠ 0) et la deuxième couche étant une couche de SiN_{z} (z ≠ 0).

2. Dispositif à semi-conducteur selon la revendication 1, dans lequel ladite couche de couverture comprend en outre une troisième couche (15 ; 16) formée sur la deuxième couche (14 ; 3) en regard de la couche semi-conductrice, ladite troisième couche étant une couche de SiO₂.

3. Dispositif à semi-conducteur comprenant un substrat diélectrique (1) constitué de verre comprenant des ions d'impureté, une couche de couverture formée sur le substrat de verre, une couche semi-conductrice (4), une couche diélectrique de grille (5) et une électrode de grille (6a), la couche de couverture comprenant une première couche (3) formée en regard du substrat de verre (1) et une deuxième couche (16) formée en regard de la couche semi-conductrice (4), la première couche (3) étant une couche de SiN_{z} (z ≠ 0) et la deuxième couche (16) étant une couche de SiO₂.

4. Dispositif à semi-conducteur comprenant un substrat diélectrique (1) constitué de verre comprenant des ions d'impureté, une couche de couverture (12 ; 2) formée sur le substrat de verre, une couche semi-conductrice (4), une couche diélectrique de grille (5) et une électrode de grille (6 ; 6a), la couche de couverture étant une couche de SiNₓO_{y} dont la valeur de y varie en continu de 2 à 0, en s'éloignant du substrat de verre (1).

5. Dispositif à semi-conducteur selon l'une quelconque des revendication 1 à 4, ladite couche de couverture constituant une première entité diélectrique, et ladite couche semi-conductrice (4), ladite couche diélectrique de grille (5) et ladite électrode de grille (6a) constituant ensemble un îlot multicouche (100) formé sur ladite première entité diélectrique ; le dispositif comprenant en outre une deuxième entité diélectrique (27a ; 20a) formée autour du côté de l'îlot multicouche (100), et une électrode de grille supérieure (6b) formée sur l'électrode de grille (6a) mentionnée en premier.

6. Procédé de fabrication d'un dispositif à semi-conducteur, le procédé comprenant les étapes consistant à préparer un substrat diélectrique (1) constitué de verre comprenant des ions d'impureté, à former successivement dans la même chambre, sur au moins un côté du substrat de verre, une première couche de SiN_{z} (z ≠ 0) (3), puis une deuxième couche de SiO₂ (16) au-dessus de la couche de SiN_{z}, et à former des transistors à couche mince sur la deuxième couche (16).

7. Procédé de fabrication d'un dispositif à semi-conducteur selon la revendication 6, le procédé comprenant les étapes consistant à former une structure multicouche comprenant une couche semi-conductrice (4) sur l'entité diélectrique des couches de SiN_{z} et de SiO₂, à former une couche diélectrique de grille (5) sur la couche semi-conductrice, et à former une couche d'électrode de grille inférieure (6a) sur la couche diélectrique de grille, à éliminer sélectivement la structure multicouche de façon que la portion restante ait la forme d'un îlot (100), à former une deuxième entité diélectrique (27a ; 20a) autour du côté de l'îlot, à former une couche d'électrode de grille supérieure (6b) sur la couche d'électrode de grille inférieure, et à graver la couche d'électrode de grille supérieure et la couche d'électrode de grille inférieure en utilisant le même motif de résist.

8. Procédé de fabrication d'un dispositif à semi-conducteur, le procédé comprenant les étapes consistant à préparer un substrat diélectrique (1) constitué de verre comprenant des ions d'impureté, à former une entité diélectrique comprenant au moins une couche de SiNₓO_{y} (x ≠ 0, y ≠ 0) (2 ; 13 ; 31), suivie d'une couche de SiN_{z} (z ≠ 0) (3 ; 14 ; 3) au-dessus de la couche de SiNₓO_{y}, sur au moins un côté du substrat de verre, et à former un transistor à couche mince sur l'entité diélectrique.

9. Procédé selon la revendication 8, dans lequel l'opération consistant à former ledit transistor à couche mince comprend les étapes consistant à former une structure multicouche qui comprend une couche semi-conductrice (4) sur l'entité diélectrique, une couche diélectrique de grille (5) sur la couche semi-conductrice, et une couche d'électrode de grille inférieure (6a) sur la couche diélectrique de grille, à éliminer sélectivement la structure multicouche de façon que la portion restante ait la forme d'un îlot (100), à former une autre entité diélectrique (27a) autour du côté de l'îlot, à former une couche d'électrode de grille supérieure (6b) sur la couche d'électrode de grille inférieure, et à graver la couche d'électrode de grille supérieure et la couche d'électrode de grille inférieure par utilisation du même motif de résist.

10. Procédé selon la revendication 8, dans lequel les couches de l'entité diélectrique sont formées dans la même chambre.

11. Procédé de fabrication d'un dispositif à semi-conducteur, le procédé comprenant les étapes consistant à préparer un substrat diélectrique (1) constitué de verre comprenant des ions d'impureté, à former une entité diélectrique comprenant une couche de SiNₓO_{y} (12 ; 2) sur au moins un côté du substrat de verre, et à former des transistors à couche mince sur l'entité diélectrique, où la couche de SiNₓO_{y} présente une valeur de y qui varie en continu de 2 à 0 quand on s'éloigne du substrat de verre.

12. Procédé selon l'une quelconque des revendications 9 à 11, dans lequel la ou chaque couche de l'entité diélectrique est formée par le procédé de pulvérisation cathodique réactive.
